# EUROPEAN PATENT APPLICATION

(11) **EP 4 450 577 A1**
(43) Date of publication of application: **23.10.2024**
(21) Application number: 22907725.0
(22) Date of filing: 16.11.2022
(51) Int. Cl.: C09J 7/22, C09J 7/40, B24B 37/24, H01L 21/306, H01L 21/3105

(54) **DOUBLE-SIDED ADHESIVE TAPE FOR ADHERING POLISHING PAD ALLOWING EASY AIR BUBBLE DISCHARGE, AND CHEMICAL-MECHANICAL POLISHING APPARATUS USING SAME**

(30) Priority: 17.12.2021 KR 20210182176
(71) Applicant: KPX Chemical Co., Ltd., Seoul 04143 (KR)
(72) Inventor: MIN, Byung Ju, Incheon 22734 (KR); HONG, Seok Ji, Hwaseong-si, Gyeonggi-do 18444 (KR); KIM, Seung Geun, Hwaseong-si, Gyeonggi-do 18466 (KR); JEONG, Jeong Yeon, Ulsan 44695 (KR); CHO, Kang Mun, Ulsan 44221 (KR)
(74) Representative: dompatent von Kreisler Selting Werner - Partnerschaft von Patent- und Rechtsanwälten mbB
(86) International application number: PCT/KR2022/018064
(87) International publication number: WO 2023/113255

(57) **Abstract**

The present invention provides a double-sided adhesive tape for adhering a polishing pad which includes an upper release film layer; a first adhesive layer; an adhesive tape substrate laminated on a lower surface of the first adhesive layer; a second adhesive layer laminated on a lower surface of the adhesive tape substrate; and a bubble discharge pattern-forming sheet layer which is laminated on a lower surface of the second adhesive layer, and includes a bubble discharge pattern formed as a protruding line on a laminated surface, and a chemical-mechanical polishing apparatus to which the adhesive tape is applied.

## Description

### [Technical Field]

The present application claims the benefit of priority based on Korean Patent Application No. 10-2021-0182176 filed on December 17, 2021, and all contents of which are incorporated as part of the present specification.

The present invention relates to a double-sided adhesive tape for adhering a polishing pad that is easy to discharge bubbles, and a chemical-mechanical polishing apparatus to which the adhesive tape is applied.

### [Background Art]

The double-sided adhesive tape is widely used to bond components and prevent or fill gaps between surfaces. For example, it can be used to apply a protective film to an electronic device to seal the electronic device and absorb shock, and is also used in a method of fixing a CMP polishing pad on a surface plate.

When fixing the CMP polishing pad on the surface plate, a double-sided adhesive tape with a relatively large area is used. When using such a double-sided adhesive tape with a large area, bubbles are often formed inside the adhesive surface. Such bubbles cause problems such as impairing the flatness of the polishing pad surface and weakening the adhesive force.

Specifically, when the polishing pad is fixed on the surface plate, the double-sided adhesive tape which is located between a lower surface of the polishing pad and an upper surface of the base table to adhere them is used. When bubbles are formed between the double-sided adhesive tape and the upper surface of the surface plate, the flatness of the upper surface of the polishing pad is impeded, and the adhesive force of the polishing pad is also weakened. In particular, when flatness is impeded as described above, it is difficult to achieve uniform polishing performance, and a problem that a protruding parts due to the bubbles wear out faster occurs.

Conventionally, when bubbles are generated at the interface as described above, the double-sided adhesive tape is pressed from the top to push the bubbles out to the edge and remove them. However, in such cases, it is often not possible to remove the bubbles.

### [Prior Art Document]

### [Patent Document]

Korean Laid-open Patent Publication No. 10-2013-0043589

### [Disclosure]

### [Technical Problem]

The present invention has been devised to solve the above problems of the related art,
it is an object thereof to provide a double-sided adhesive tape for adhering a polishing pad, which can easily remove bubbles generated on the adhering surface when using the double-sided adhesive tape, and a chemical-mechanical polishing apparatus to which the double-sided adhesive tape is applied.

### [Technical Solution]

In order to achieve the above object, the present invention provides a double-sided adhesive tape for adhering a polishing pad, which includes:
an upper release film layer;
a first adhesive layer;
an adhesive tape substrate laminated on a lower surface of the first adhesive layer;
a second adhesive layer laminated on a lower surface of the adhesive tape substrate; and
a bubble discharge pattern-forming sheet layer which is laminated on a lower surface of the second adhesive layer, and includes a bubble discharge pattern formed as a protruding line on a laminated surface.

In an embodiment of the present invention, the bubble discharge pattern-forming sheet layer may be laminated in a state in which the pattern formed as the protruding line penetrates into the lower surface of the second adhesive layer.

In an embodiment of the present invention, the upper release film layer and the bubble discharge pattern-forming sheet layer may be removed when used.

In an embodiment of the present invention, the second adhesive layer may be adhered to a surface from which a bubble removal is required.

In an embodiment of the present invention, the pattern formed as the protruding line may be a stripe pattern or a polygonal pattern.

In an embodiment of the present invention, the polygonal pattern may be a square pattern formed by intersecting linear protruding lines.

In an embodiment of the present invention, a widthwise cross section of the protruding line may be a polygon, a circle with a part of a lower portion cut off, or an oval with a part of a lower portion cut off.

In an embodiment of the present invention, a longest width of the protruding lines may be 50 um to 250 um, and a height may be 5 um to 30 um.

In an embodiment of the present invention, the square pattern may have a width between two non-adjacent sides of 300 um to 1000 um.

In an embodiment of the present invention, the bubble discharge pattern-forming sheet layer may include a forming sheet with a bubble discharge pattern formed as the protruding line formed on one side thereof, and a substrate film adhered to the other side of the forming sheet.

Furthermore, the present invention provides a chemical-mechanical polishing apparatus which includes:
a polishing pad; and
a surface plate on which the polishing pad is fixed,
wherein the polishing pad is fixed on the surface plate, using the double-sided adhesive tape for adhering the polishing pad of the present invention.

In an embodiment of the present invention, a lower surface of the polishing pad may be adhered to a first adhesive layer of the double-sided adhesive tape, and
an upper surface of the surface plate may be adhered to a second adhesive layer of the double-sided adhesive tape.

### [Advantageous Effects]

The double-sided adhesive tape for adhering a polishing pad of the present invention provides an effect in which, when bubbles are generated at the adhesive interface, the bubbles can be easily discharged outward from the adhesive interface by applying pressure, by forming a trench portion that can discharge bubbles on an outer adhesive surface of an adhesive layer.

In addition, the chemical-mechanical polishing apparatus of the present invention provides an effect which has excellent flatness on the upper surface of the polishing pad, exhibits uniform polishing performance, and improves the service life of the polishing pad by strongly adhering the polishing pad to the surface plate.

### [Description of Drawings]

FIG. 1 is a schematic cross-sectional view showing an embodiment of the double-sided adhesive tape for adhering a polishing pad of the present invention.
FIG. 2 is an exploded cross-sectional view schematically showing an embodiment of the double-sided adhesive tape for adhering a polishing pad of the present invention.
FIG. 3 is a perspective view illustrating an embodiment of a forming sheet included in the double-sided adhesive tape for adhering a polishing pad of the present invention.
FIG. 4 is a photograph illustrating an adhesion state of a conventional double-sided adhesive tape for adhering a polishing pad.
FIG. 5 is a schematic cross-sectional view showing a generation form of bubbles when adhering the polishing pad using the conventional double-sided adhesive tape for adhering the polishing pad.
FIG. 6 is a schematic cross-sectional view showing another embodiment of the double-sided adhesive tape for adhering the polishing pad of the present invention.
FIG. 7 is a cross-sectional view illustrating a state in which a polishing pad is adhered to a surface plate, using the double-sided adhesive tape for adhering the polishing pad of the present invention.
FIG. 8 is a perspective view schematically showing an embodiment of the chemical-mechanical polishing apparatus of the present invention.
FIG. 9 is a photograph illustrating a bubble removal aspect when the double-sided adhesive tape for adhering the polishing pad of the present invention is used (Example 1) and when the conventional double-sided adhesive tape for adhering the polishing pad is used (Comparative Example 1).
FIG. 10 is a photographs estimating whether liquid penetrates (using ink) in the double-sided adhesive tape for adhering the polishing pad of the present invention.
FIG. 11 is a photograph illustrating a test process and results of measuring the adhesive strength after inducing liquid penetration in the double-sided adhesive tape for adhering polishing pad of the present invention (Example 1) and the conventional double-sided adhesive tape for adhering polishing pad (Comparative Example 1).
FIG. 12 is a photograph illustrating a surface of a second adhesive layer included in the double-sided adhesive tape for adhering the polishing pad of the present invention.

### [Best Mode]

Hereinafter, the embodiments of the present invention will be described in detail with reference to the accompanying drawings so that a person having ordinary knowledge in the technical field to which the present invention pertains can easily implement the present invention. However, the present invention can be embodied in various different forms and is not limited to the embodiments described herein. Similar parts are denoted by the same reference numerals throughout the specification.

When a certain component is referred to as being "connected, equipped, or installed" to another component, the former may be directly connected or installed to the latter, but it should be understood that there may be other components between them. On the other hand, when a certain component is referred to as being "directly connected, equipped, or installed" to another component, it should be understood that there is no other component between them. Meanwhile, other expressions describing a relationship between the components, i.e., "on top" and "directly on top," or "between" and "right between," or "adjacent to" and "directly adjacent to," should be interpreted similarly.

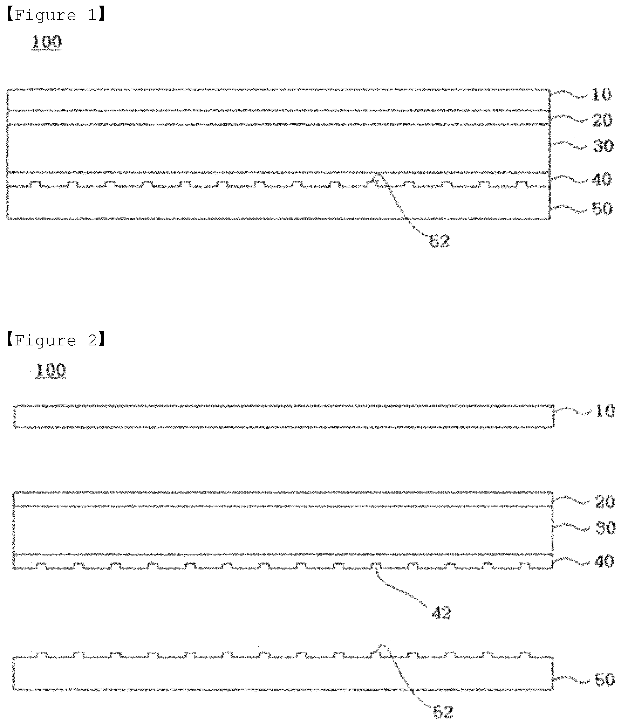

FIG. 1 is a schematic cross-sectional view showing an embodiment of a double-sided adhesive tape for adhering a polishing pad of the present invention, and FIG. 2 is an exploded cross-sectional view schematically showing an embodiment of the double-sided adhesive tape for adhering the polishing pad of the present invention.

As shown in FIGS. 1 and 2, a double-sided adhesive tape 100 for adhering a polishing pad of the present invention includes an upper release film layer 10; a first adhesive layer 20; an adhesive tape substrate 30 laminated on a lower surface of the first adhesive layer; a second adhesive layer 40 laminated on a lower surface of the adhesive tape substrate; and a bubble discharge pattern-forming sheet layer 50 which is laminated on the lower surface of the second adhesive layer and includes a bubble discharge pattern formed as a protruding line on the laminated surface.

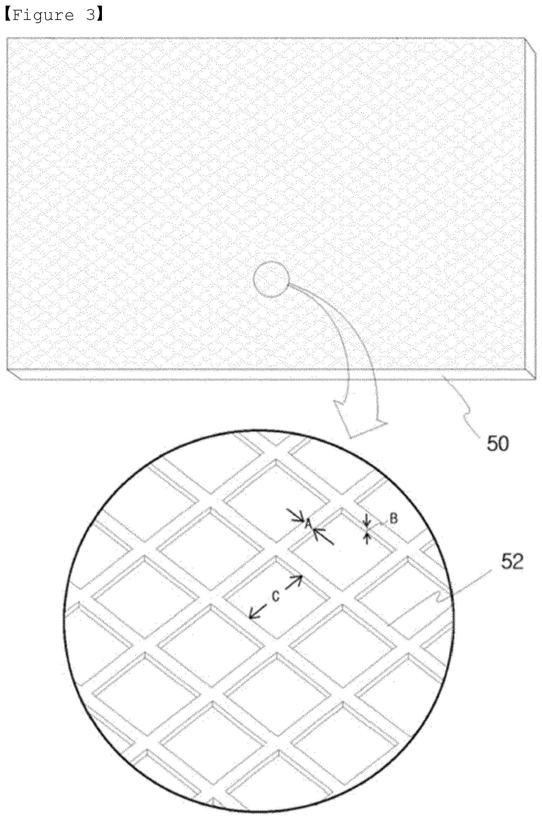

FIG. 3 is a perspective view illustrating an embodiment of the forming sheet layer 50 included in the double-sided adhesive tape 100 for adhering the polishing pad of the present invention.

In an embodiment of the present invention, the bubble discharge pattern-forming sheet layer 50 may have a pattern 52 formed as a protruding line laminated in an recessed state on the lower surface of the second adhesive layer 40 as shown in FIG. 1.

As described above, in a case where the pattern 52 formed as the protruding line is laminated in an recessed state on the lower surface of the second adhesive layer 40, when the bubble discharge pattern-forming sheet layer 50 is removed during use, the bubble discharge pattern 42 is engraved on the lower surface of the second adhesive layer 40 coupled there to.

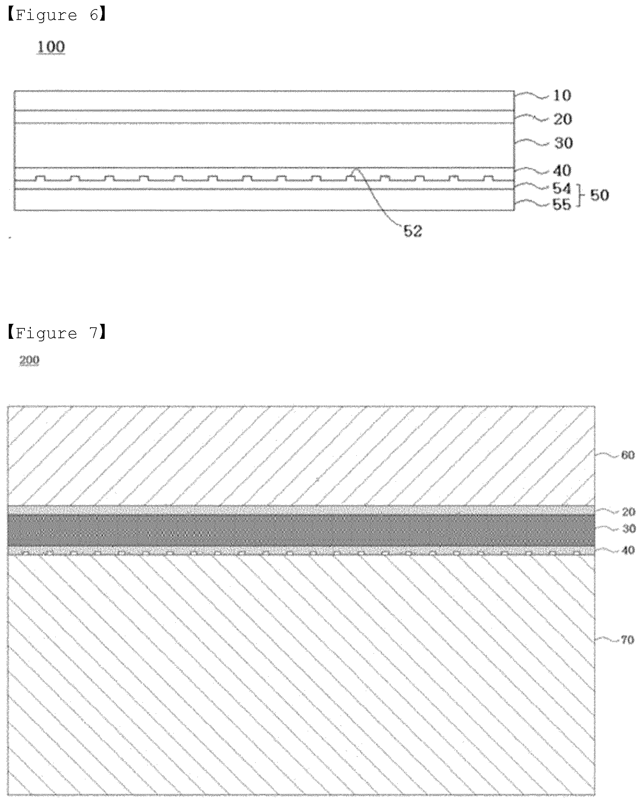

Therefore, when the double-sided adhesive tape 100 for adhering the polishing pad is adhered to the upper surface of a surface plate (FIG. 7, 70) by the second adhesive layer 40, even if bubbles are generated between the polishing pad (FIG. 7, 60) and the surface plate 70, they can be easily removed by the engraved bubble discharge pattern (e.g., trench). FIG. 7 schematically shows a shape in which the double-sided adhesive tape 100 for adhering the polishing pad of the present invention is located between the polishing pad 60 and the surface plate 70 to fix the polishing pad 60 to the surface plate 70.

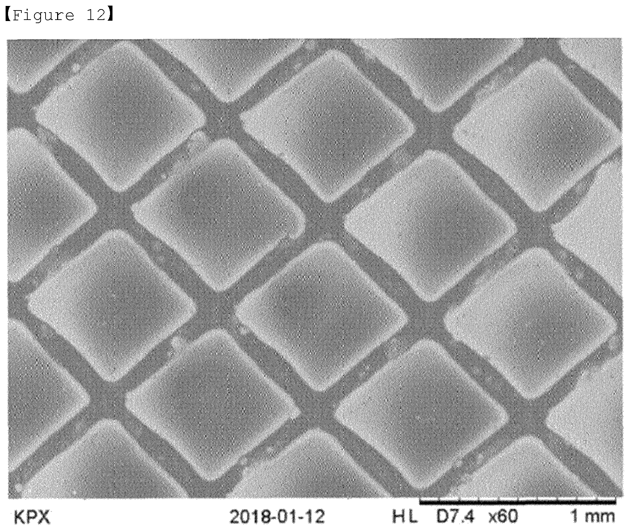

As shown in FIG. 7, the double-sided adhesive tape 100 for adhering the polishing pad is adhered between the polishing pad 60 and the surface plate 70 in a state in which the upper release film layer 10 and the bubble discharge pattern-forming sheet layer 50 is removed. FIG. 12 illustrates a photograph of the shape of the second adhesive layer 40 from which the upper release film layer 10 and the bubble discharge pattern-forming sheet layer 50 are removed.

In an embodiment of the present invention, the second adhesive layer 40 may be adhered to a surface from which bubbles need to be removed, for example, the surface plate 70.

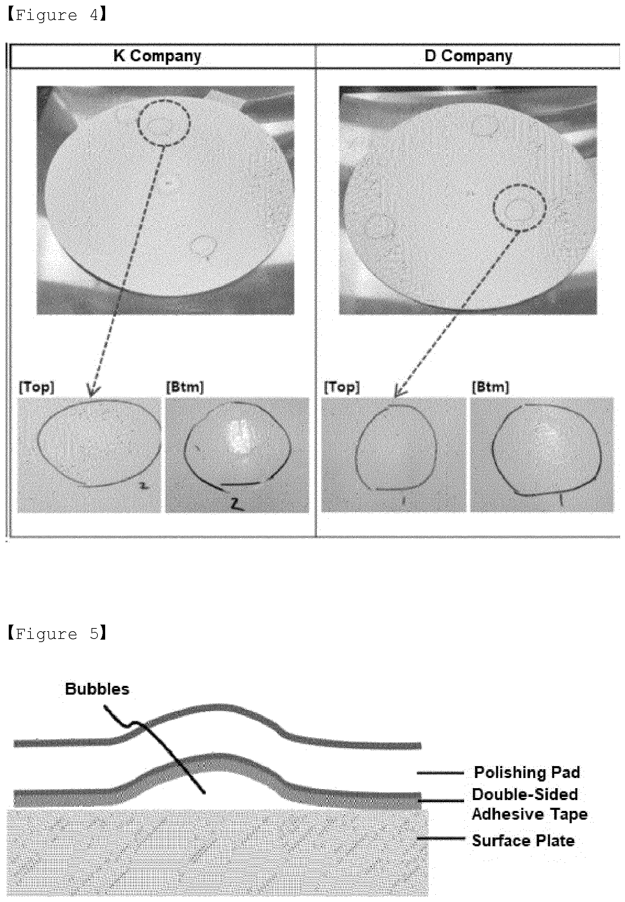

According to the related art, when the polishing pad was fixed on the surface plate using the double-sided adhesive tape for adhering the polishing pad as described above, bubbles were often formed between the double-sided adhesive tape and the surface plate as shown in FIGS. 4 and 5, and it was very difficult to remove such bubbles.

When bubbles exist between the polishing pad and the surface plate as described above, the flatness of the upper surface of the polishing pad is hindered, and the adhesive strength of the polishing pad is also weakened. In particular, when the flatness is hindered as described above, it is difficult for the polishing pad to exhibit uniform polishing performance, and the protruding portion due to the bubbles wears out faster.

However, when the double-sided adhesive tape 100 for adhering the polishing pad of the present invention is used, the above problems can be easily resolved.

In an embodiment of the present invention, a pattern 52 formed as the protruding line may be formed by a stripe pattern or a polygonal pattern.

The polygonal pattern may be various shapes formed by the linear protruding line, for example, polygons such as a triangle, a square, a pentagon, and a hexagon, and the shape of the polygon is not particularly limited.

In an embodiment of the present invention, the polygonal pattern may be a square pattern formed by the linear protruding lines while intersecting each other. For example, such a square pattern may be in the form shown in FIG. 3. Since such a square pattern may form a linearly engraved bubble discharge pattern 42 (e.g., a trench) on the lower surface of the second adhesive layer 40, it may be advantageous for efficiently removing bubbles through the pattern.

In an embodiment of the present invention, the widthwise cross section of the protruding line may be a polygon, a circle with a part of the lower portion cut off, or an oval with a part of the lower portion cut off. The polygon may be, for example, a triangle, a square, etc., but is not limited thereto.

In an embodiment of the present invention, a longest width of the protruding line (FIG. 3, A) may be 50 um to 250 um, preferably 140 um to 180 um, and a height (FIG. 3, B) may be 5 um to 30 um, preferably 7 um to 15 um. When the longest width of the protruding line is smaller than the above range, the bubble removal efficiency may decrease, and when it exceeds the above range, the adhesive strength of the second adhesive layer 40 may decrease, which is not preferable.

The longest width of the protruding line may be formed at the lowest end portion of the protruding line which engages with a surface on which the protruding line is not formed. However, if the widthwise cross section of the protruding line is a circle with a part of the lower portion cut off or an oval with a part of the lower portion cut off, it may not be formed at the lowermost end portion of the protruding line.

In an embodiment of the present invention, the square pattern may have a width between two sides not adjacent to each other (FIG. 3, C) of 300 um to 1000 um, preferably 500 um to 650 um. If the width between the two sides is smaller than the above range, the adhesive strength of the second adhesive layer 40 may decrease, and if it exceeds the above range, the bubble removal efficiency may decrease, which is not preferable.

In the square pattern, there are two widths between two sides not adjacent to each other, and these two widths may be formed to be the same size.

FIG. 6 is a cross-sectional view showing another embodiment of the double-sided adhesive tape for adhering the polishing pad of the present invention. As shown in FIG. 6, the bubble discharge pattern-forming sheet layer 50 may include a forming sheet 54 having a bubble discharge pattern formed as the protruding line formed on one side thereof, and a substrate film 55 adhered to the other side of the forming sheet. At this time, the forming sheet 54 and the substrate film 55 adhered to the other side of the forming sheet may be separated separately when using the double-sided adhesive tape 200 for adhering a polishing pad, or they are provided in a state of being adhered and may be separated at a time.

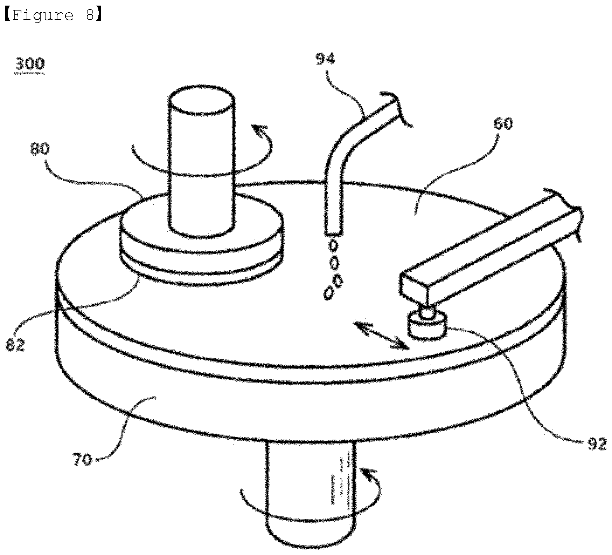

FIG. 8 is a perspective view schematically showing an embodiment of the chemical-mechanical polishing apparatus 300 of the present invention.

The chemical-mechanical polishing apparatus 300 of the present invention includes a polishing pad 60; and a surface plate 70 on which the polishing pad is fixed, and the polishing pad has a feature of being fixed on the surface plate, using a double-sided adhesive tape for adhering a polishing pad (not described) of the present invention.

The chemical-mechanical polishing apparatus 300 of the present invention has a feature that there are no bubbles between the double-sided adhesive tape for adhering the polishing pad and the surface plate 70. Therefore, the chemical-mechanical polishing apparatus 300 of the present invention provides an effect of improving the service life of the polishing pad, since the polishing pad 60 has excellent flatness on the upper surface thereof, exhibits uniform polishing performance, and is strongly adhered on the surface plate 70.

In the chemical-mechanical polishing apparatus 300, the lower surface of the polishing pad 60 may be adhered to the first adhesive layer 10 of the double-sided adhesive tape, and the upper surface of the surface plate 70 may be adhered to the second adhesive layer 40 of the double-sided adhesive tape.

In addition to the above-mentioned characteristic configurations, the chemical-mechanical polishing apparatus 300 can further include a polishing head 80, a conditioner 90, an abrasive slurry supply nozzle 94, and the like. Furthermore, in addition to the above-mentioned configurations, other components provided in the chemical-mechanical polishing apparatus known in this field may be included without limitation.

Hereinafter, the present invention will be described in detail using the examples and the comparative examples. However, the embodiment according to the present invention can be modified into various other forms, and the scope of the present invention should not be interpreted as being limited to the embodiments described below. The embodiments of the present invention are provided to explain the present invention in more detail to those with average knowledge in the art.

### Example 1: Manufacturing of Double-Sided Adhesive Tape for Adhering Polishing Pad

A first adhesive layer of 55 um thickness was laminated on the upper surface of a 50 um thick PET adhesive tape substrate by using an acrylic adhesive, and a 25 um thick PET release film was laminated on the upper surface of the first adhesive layer.

Next, the lower surface of the adhesive tape substrate was turned upward, a second adhesive layer of 40 um thickness was laminated using a rubber-based adhesive, a forming sheet formed on one side of a square pattern (FIG. 3, 52) formed as the protruding line, and a bubble discharge pattern-forming sheet with a substrate film adhered to the other side of the forming sheet were prepared, and the square pattern was laminated to be recessed into the second adhesive layer to manufacture a double-sided adhesive tape for adhering the polishing pad.

The forming sheet layer film was manufactured by applying a polyethylene resin to a thickness of 35 um on a PET substrate film having a thickness of 75 um, pressing the upper surface with a molding roller before the polyethylene resin solidifies to form a square pattern (FIG. 3, 52) formed as the protruding line, and then curing the film.

### Comparative Example 1: Manufacturing of Double-Sided Adhesive Tape for Adhering Polishing Pad

As in Example 1, an upper release film layer, a first adhesive layer, an adhesive tape substrate, and a second adhesive layer were laminated.

The double-sided adhesive tape for adhering the polishing pad was manufactured by laminating a PET release film having a thickness of 25 um on the lower surface of the second adhesive layer.

### Test Example 1: Evaluation of Bubble Removal Ability

The bubble discharge pattern-forming sheet was removed from the double-sided adhesive tape for adhering the polishing pad manufactured in Example 1, and the lower surface of the second adhesive layer was adhered to an acrylic surface plate and pressure was applied to remove bubbles.

Meanwhile, the release film was removed from the second adhesive layer of the double-sided adhesive tape for adhering the polishing pad manufactured in Comparative Example 1, and the lower surface of the second adhesive layer was adhered to the acrylic surface plate and pressure was applied to remove bubbles.

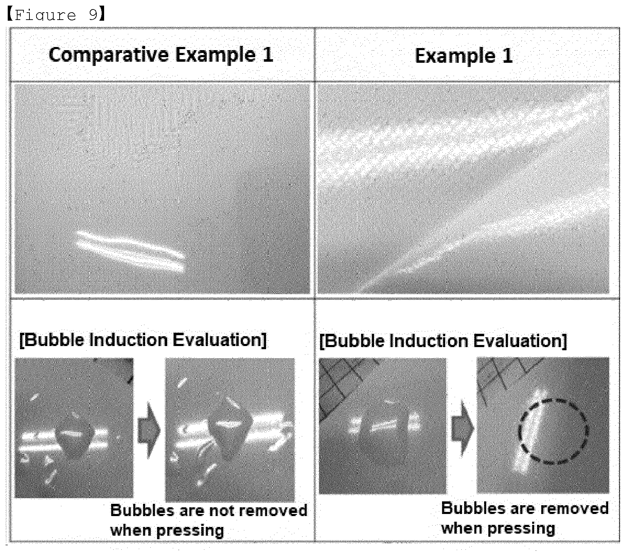

The test results are shown in FIG. 9. As can be seen in FIG. 9, in Example 1 in which the double-sided adhesive tape for adhering the polishing pad of the present invention was adhered, no bubbles remained after removing the bubbles by applying pressure, but in Comparative Example 1 in which a conventional double-sided adhesive tape with no bubble discharge pattern-forming sheet was used, many bubbles remained even after removing the bubbles by applying pressure.

### Test Example 2: Evaluation of Adhesive Strength and Shear Strength

The adhesive strength and shear strength were measured using the double-sided adhesive tape samples for adhering the polishing pad of Example 1 and Comparative Example 1, which were adhered to an acrylic surface plate in the same manner as in Test Example 1.

The adhesive strength was measured using a tensile strength tester (UTM), and the shear strength was measured using a tensile strength tester (UTM), and the measurement results are shown in Table 1 below.

**[Table 1]**

| Classification | | Comparative Example 1 | Example 1 |
|---|---|---|---|
| Adhesive strength | Permanent side (Acceptable range: 1900~2500g/inch) | 2312 | 2428 |
| | Removal side (Acceptable range: 1050~1450g/inch) | 1400 | 1323 |
| Shear strength | Removal side (Acceptable range: 16~26kg/cm²) | 21.8 | 22.2 |

| | | | |
|---|---|---|---|
| (Note) Permanent side: surface on which the double-sided adhesive tape is attached to pad (bottom) Removal side: surface on which the double-sided adhesive tape is attached to the CMP Platen (=embossed side) | | | |

From the above Table 1, it was confirmed that the adhesive strength and shear strength of the double-sided adhesive tape for adhering the polishing pad of Example 1 are at the same level as those of Comparative Example 1, even though the second adhesive surface includes the bubble discharge pattern, and that the level is suitable for use.

### Test Example 3: Evaluation of Adhesive Residue Generation

The degree of adhesive residue generation was evaluated, using a double-sided adhesive tape sample for adhering the polishing pad of Example 1 that was adhered to an acrylic surface plate in the same manner as in Test Example 1 above.

Specifically, the double-sided adhesive tape for adhering the polishing pad was removed 10 hours after being adhered to the acrylic surface plate, and the presence or absence of residue was confirmed.

As a result of the test, it was confirmed that no residue remained on the surface plate when the double-sided adhesive tape was removed.

### Test Example 4: Presence or Absence of Liquid Penetration on Side And Evaluation of Adhesive Strength After Liquid Penetration

### (1) Side liquid penetration test

The side liquid penetration test was performed, using the double-sided adhesive tape sample for adhering the polishing pad of Example 1 that was adhered to an acrylic surface plate in the same manner as in Test Example 1 above.

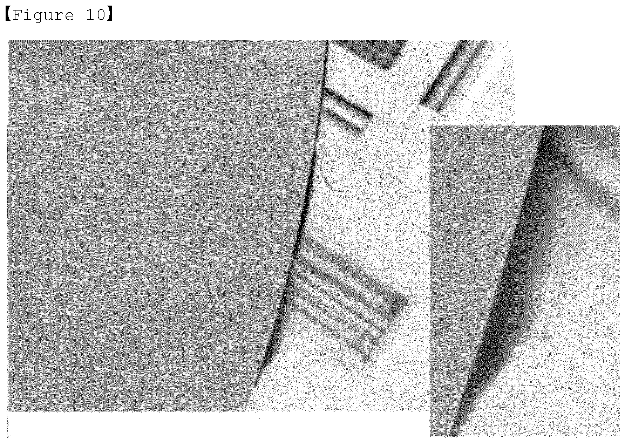

Specifically, ink was supplied to an edge portion of the double-sided adhesive tape for adhering the polishing pad adhered to the acrylic surface plate, and after maintained for 10 hours, the presence or absence of ink penetration was confirmed. As shown in FIG. 10, as the above test result, no ink penetration into the edge portion of the double-sided adhesive tape for adhering the polishing pad was observed.

### (2) Evaluation of Adhesive Strength After Liquid Penetration Induction

The double-sided adhesive tape sample for adhering the polishing pad of Example 1 and Comparative Example 1 that was adhered to an acrylic surface plate in the same manner as in Test Example 1 above was manufactured and used.

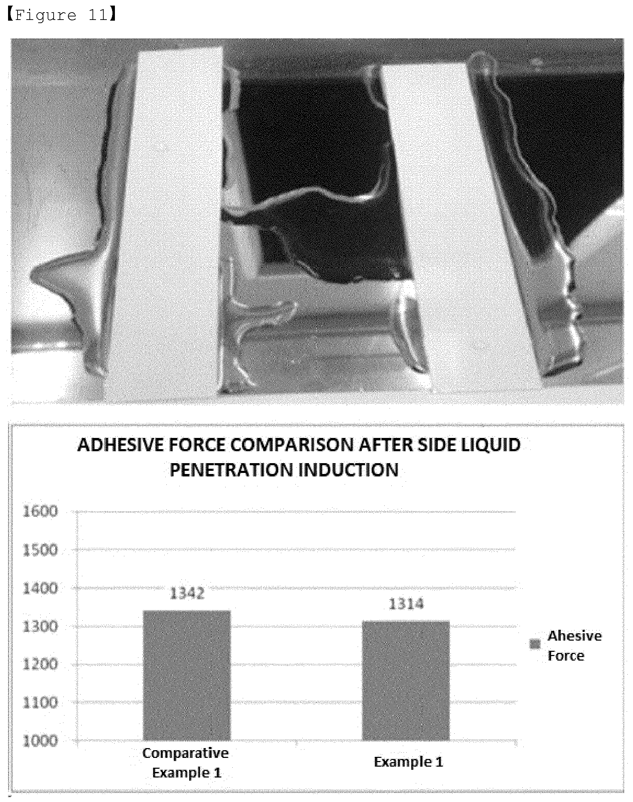

As shown in FIG. 11, water was supplied to the edge portion of each of the double-sided adhesive tape samples for adhering the polishing pad, and after maintained for 10 hours, the adhesive strength was measured using a tensile strength tester (UTM), and the results are shown in FIG. 11.

From the table of FIG. 11, it was confirmed that the adhesive strength after liquid penetration of the double-sided adhesive tape for adhering the polishing pad of Example 1 was at the same level as that of Comparative Example 1, despite the inclusion of a bubble discharge pattern on the second adhesive surface.

Although the present invention has been described in relation to the above preferred embodiment, various modifications or variations can be made without departing from the gist and scope of the present invention. Accordingly, the appended claims will include such modifications or variations as long as they fall within the gist of the present invention.

### [Description of symbols]

10: Upper release film layer 20: First adhesive layer
30: Adhesive tape substrate 40: Second adhesive layer
42: Bubble discharge pattern
50: Bubble discharge pattern-forming sheet layer
52: Pattern formed as protruding line
54: Forming sheet 55: Substrate film
60: Polishing pad 70: Surface plate
80: Polishing head 82: Wafer
92: Conditioner 94: Polishing slurry supply nozzle
100, 200: Double-sided adhesive tape for adhering polishing pad
300: Chemical-mechanical polishing apparatus

## Claims

1. A double-sided adhesive tape for adhering a polishing pad, comprising:
an upper release film layer;
a first adhesive layer;
an adhesive tape substrate laminated on a lower surface of the first adhesive layer;
a second adhesive layer laminated on a lower surface of the adhesive tape substrate; and
a bubble discharge pattern-forming sheet layer which is laminated on a lower surface of the second adhesive layer, and includes a bubble discharge pattern formed as a protruding line on a laminated surface.

2. The double-sided adhesive tape for adhering the polishing pad according to claim 1, wherein the bubble discharge pattern-forming sheet layer is laminated in a state in which the pattern formed as the protruding line penetrates into the lower surface of the second adhesive layer.

3. The double-sided adhesive tape for adhering the polishing pad according to claim 1, wherein the upper release film layer and the bubble discharge pattern-forming sheet layer are removed when used.

4. The double-sided adhesive tape for adhering the polishing pad according to claim 3, wherein the second adhesive layer is adhered to a surface from which a bubble removal is required.

5. The double-sided adhesive tape for adhering the polishing pad according to claim 1, wherein the pattern formed as the protruding line is a stripe pattern or a polygonal pattern.

6. The double-sided adhesive tape for adhering the polishing pad according to claim 5, wherein the polygonal pattern is a square pattern formed by intersecting linear protruding lines.

7. The double-sided adhesive tape for adhering the polishing pad according to claim 1, wherein a widthwise cross section of the protruding line is a polygon, a circle with a part of a lower portion cut off, or an oval with a part of a lower portion cut off.

8. The double-sided adhesive tape for adhering the polishing pad according to claim 1, wherein a longest width of the protruding lines is 50 um to 250 um, and a height is 5 um to 30 um.

9. The double-sided adhesive tape for adhering the polishing pad according to claim 8, wherein the square pattern has a width between two non-adjacent sides of 300 um to 1000 um.

10. The double-sided adhesive tape for adhering the polishing pad according to claim 1, wherein the bubble discharge pattern-forming sheet layer includes a forming sheet with a bubble discharge pattern formed as the protruding line formed on one side thereof, and a substrate film adhered to the other side of the forming sheet.

11. A chemical-mechanical polishing apparatus, comprising:
a polishing pad; and
a surface plate on which the polishing pad is fixed,
wherein the polishing pad is fixed on the surface plate, using the double-sided adhesive tape for adhering the polishing pad according to claim 1.

12. The chemical-mechanical polishing apparatus according to claim 11, wherein a lower surface of the polishing pad is adhered to a first adhesive layer of the double-sided adhesive tape, and an upper surface of the surface plate is adhered to a second adhesive layer of the double-sided adhesive tape.
